# EUROPÄISCHE PATENTSCHRIFT

(11) **EP 3 658 882 B1**
(45) Veröffentlichungstag und Bekanntmachung des Hinweises auf die Patenterteilung: **03.01.2024**
(21) Anmeldenummer: 18743471.7
(22) Anmeldetag: 18.07.2018
(51) Int. Cl.: G01M 13/04, G01R 31/34

(54) **VORRICHTUNG, SYSTEM UND VERFAHREN ZUR BESTIMMUNG DES ZUSTANDS EINES MECHANISCHEN BAUTEILS**
DEVICE, SYSTEM, AND METHOD FOR DETERMINING THE STATE OF A MECHANICAL COMPONENT
DISPOSITIF, SYSTÈME ET PROCÉDÉ DE DÉTERMINATION DE L'ÉTAT D'UN COMPOSANT MÉCANIQUE

(30) Priorität: 24.07.2017 DE 102017212666
(43) Veröffentlichungstag der Anmeldung: 03.06.2020
(60) Teilanmeldung: 23199034.2
(73) Patentinhaber: VDEh-Betriebsforschungsinstitut GmbH, 40237 Düsseldorf (DE)
(72) Erfinder: NKWITCHOUA DJANGANG, Achille Fabien, 47259 Duisburg (DE); POLZER, Jan, 47058 Duisburg (DE)
(74) Vertreter: König Szynka Tilmann von Renesse Patentanwälte Partnerschaft mbB Düsseldorf
(86) Internationale Anmeldenummer: PCT/EP2018/069562
(87) Internationale Veröffentlichungsnummer: WO 2019/020473

(56) Entgegenhaltungen:
- WO-A1-2006/134068
- WO-A1-2008/000285
- WO-A1-2015/043619
- US-A- 5 936 410
- US-A1- 2015 355 075

## Beschreibung

Die Erfindung betrifft eine Vorrichtung zur Bestimmung des Zustands eines mechanischen Bauteils, bei dem im Einsatz des Bauteils zumindest ein Teil des Bauteils relativ zu einem anderen Bauteil bewegt wird. Ferner betrifft die Erfindung ein System und ein Verfahren zur Bestimmung des Zustands eines mechanischen Bauteils.

Sowohl bei der Herstellung von mechanischen Bauteilen, bei denen im Einsatz des Bauteils zumindest ein Teil des Bauteils relativ zu einem anderen Bauteil bewegt wird, wie insbesondere Antrieben oder Lagern, als auch beim Betrieb mechanischer Bauteile besteht ein Interesse an Informationen über den Zustand des mechanischen Bauteils. Bei der Herstellung eines mechanischen Bauteils besteht insbesondere ein Interesse daran, festzustellen, ob das mechanische Bauteil den bei seiner Auslegung und Konstruktion festgelegten Qualitätsstandards entspricht und insbesondere alle bei der Konstruktion vorgesehenen Bauteile enthält, diese Bauteile die gewünschte Form haben, diese Bauteile in der gewünschten Qualität vorliegen (beispielsweise rißfrei und ohne Lunker) und ob Teile des mechanischen Bauteils die bei der Auslegung und Konstruktion des Bauteils festgelegten Abstände einzelner Bauteile zueinander einhalten, insbesondere festgelegte Toleranzen. Ferner interessiert bei der Herstellung neuer mechanischer Bauteile, ob das mechanische Bauteil die bei seiner Auslegung und Konstruktion festgelegte Schmierung, insbesondere auch hinsichtlich des Ortes, an dem sich die Schmierung befinden soll, sowie hinsichtlich der Qualität des eingesetzten Schmiermittels, aber auch hinsichtlich der Menge des vorzusehenden Schmiermittels hat.

Bei dem Betrieb eines mechanischen Bauteils, bei dem im Einsatz des Bauteils zumindest ein Teil des Bauteils relativ zu einem anderen Bauteil bewegt wird, besteht insbesondere ein Interesse daran, festzustellen, ob das mechanische Bauteil den bei seiner Auslegung und Konstruktion festgelegten Qualitätsstandards weiterhin entspricht, bzw. der bei der Auslegung und Konstruktion berücksichtigte Alterungsprozess in dem Maße eintritt, wie geplant, und insbesondere alle bei der Konstruktion vorgesehenen Bauteile weiterhin vorhanden sind, diese Bauteile weiterhin die gewünschte, bzw. dem erwarteten Alterungsprozess entsprechende Form haben, diese Bauteile weiterhin in der gewünschten Qualität vorliegen (beispielsweise rißfrei und ohne Lunker) und ob Teile des mechanischen Bauteils die bei der Auslegung und Konstruktion des Bauteils festgelegten Abstände einzelner Bauteile zueinander einhalten, insbesondere festgelegte Toleranzen. Ferner interessiert bei dem Betrieb mechanischer Bau-teile, ob das mechanische Bauteil die bei seiner Auslegung und Konstruktion festgelegte Schmierung, insbesondere auch hinsichtlich des Ortes, an dem sich die Schmierung befinden soll, sowie hinsichtlich der Qualität des eingesetzten Schmiermittels, aber auch hinsichtlich der Menge des vorzusehenden Schmiermittels hat.

Im Stand der Technik ist es bekannt, den Zustand eines mechanischen Bauteils, bei dem im Einsatz des Bauteils zumindest ein Teil des Bauteils relativ zu einem anderen Bauteil bewegt wird, mit mechanischen Messmethoden zu ermitteln. So werden Messungen und Abstände zueinander häufig mittels entsprechender Messmethoden, aber vor allem Schieblehren untersucht. Hinsichtlich der Schmierung ist es häufig vorgesehen, Proben zu nehmen und diese Proben hinsichtlich der Qualität des Schmiermittels, insbesondere auch im Hinblick auf eine mögliche Alterung, zu prüfen. Ferner ist es im Betrieb von mechanischen Bauteilen bekannt, mit Wartungsplänen zu arbeiten, die häufig auf Betriebsstunden oder beispielsweise gefahrenen Kilometern (bei einem Kraftfahrzeug) basieren.

Aus WO 2015/043619 A1 ist eine Vorrichtung und ein Verfahren nach dem Oberbegriff der Ansprüche 1 bzw. 4 bekannt.

WO 2006/134068 A1 offenbart eine Anordnung und ein Verfahren zur Lagerstromüberwachung eines Elektromotors.

US 5 936 410 A offenbart ein hydrodynamisches Lager mit Mitteln zur Überwachung der Kapazität zwischen dem Rotor und dem Stator des hydrodynamischen Lagers.

WO 2008/000285 A1 offenbart ein Verfahren zum Anzeiegn von Ermüdungsschäden an einem metallischen Gegenstand.

Vor diesem Hintergrund lag der Erfindung die Aufgabe zugrunde, eine Vorrichtung sowie ein System und ein Verfahren zur Bestimmung des Zustands eines mechanischen Bauteils, bei dem im Einsatz des Bauteils zumindest ein Teil des Bauteils relativ zu einem anderen Bauteil bewegt wird, vorzuschlagen, die sich insbesondere einfach durchführen lässt.

Diese Aufgabe wird durch die Vorrichtung gemäß Anspruch 1, das System gemäß Anspruch 3 und das Verfahren gemäß Anspruch 4 gelöst. Vorteilhafte Ausführungsformen sind in Anspruch 2 und der hier nachfolgenden Beschreibung wiedergegeben.

Die Erfindung geht von dem Grundgedanken aus, den Zustand eines mechanischen Bauteils, bei denen im Einsatz des Bauteils zumindest ein Teil des Bauteils relativ zu einem anderen Bauteil bewegt wird, nicht mit mechanischen Messmethoden zu ermitteln, sondern durch die Bestimmung einer elektrischen Größe oder durch die Bestimmung einer Änderung einer elektrischen Größe, die erfindungsgemäß eine elektrische Spannung ist. Die Erfindung hat nämlich erkannt, dass eine Spannung, die an dem mechanischen Bauteil bestimmt wird, eine Aussage über den Zustand des mechanischen Bauteils geben kann.

Es wurde erkannt, dass bereits der absolute Wert der Spannung eine Aussage über den Zustand des mechanischen Bauteils geben kann. Es wurde aber auch erkannt, dass das Beobachten der Änderung der Spannung über einen Zeitabschnitt eine Aussage über den Zustand eines mechanischen Bauteils zulässt.

Ebenso kann die Betrachtung der Änderungsrate eine Aussage über den Zustand des mechanischen Bauteils liefern, also die Erkenntnis darüber, dass sich beispielsweise die Impedanz in einem ersten Beobachtungszeitraum mit einer ersten Rate und in einem zweiten Beobachtungszeitraum mit einer zweiten Rate ändert.

Die Betrachtung wird über eine Motorwelle des Bauteils eingeleitetes Spannungssignal erfolgen, da das elektrische, messbare Signalübertragungsverhalten der Spannung vom Zustand des bewegbaren Bauteils abhängt. Es ist auch möglich, dass zusätzlich ein parasitäres Spannungssignal betrachtet wird.

Mit den vorgestellten Verfahren kann man eine detaillierte Eigenschaftsprüfung der montierten, neuen Lager durchführen und somit auch die Maßhaltigkeit des Gesamtsystems überwachen.

Mit der Erfindung kann insbesondere als Zustand des mechanischen Bauteils, bei dem im Einsatz des Bauteils zumindest ein Teil des Bauteils relativ zu einem anderen Bauteil bewegt wird, festgestellt werden, ob das Bauteil geschmiert ist und welcher Grad der Schmierung (insbesondere die Änderung der Dicke des Schmierfilms) vorliegt und welche Güte (insbesondere welcher Alterungszustand) das Schmiermittel hat. Die Erfindung bietet beispielsweise die Möglichkeit der frühzeitigen Bewertung der Schmierstoffqualität in einem Lager oder in einem Antriebsstrang. Dies ist wichtig, da sehr viele Lagerdefekte auf Grund einer ungenügenden Schmierung erfolgen. Die Erfindung lässt eine Analyse auch von sehr langsam drehenden Lagern zu, die beispielsweise mit einer Schwingungsanalyse kaum analysierbar sind. Die Erfindung erlaubt die frühzeitige Zustandserkennung des Lagers oder des Getriebes oder des Antriebsstrangs bzw. mechanische Beschädigungen dieser. Mit der Erfindung kann als Zustand des bewegbaren mechanischen Bauteils festgestellt werden, ob mechanische Schäden am oder im Bauteil vorliegen, also Abweichungen von der bei der Auslegung und Konstruktion des mechanischen Bauteils festgelegten Form der Teile des Bauteils bestehen. Ebenso kann die Maßhaltigkeit von Teilen des mechanischen Bauteils geprüft werden. Ebenso sind Abweichungen in Werkstoffqualitäten detektierbar, nämlich solche, die einen Einfluss auf die elektrische Leitfähigkeit haben.

Als zu bestimmende elektrische Größe bzw. als elektrische Größe, deren Änderung erfindungsgemäß bestimmt wird, wird die elektrische Spannung, die am Bauteil anliegt bestimmt.

Die erfindungsgemäße Vorrichtung zur Bestimmung des Zustands eines mechanischen Bauteils, das ein Lager ist, weist ein Messgerät auf, das als Voltmeter ausgestaltet ist. Die Auswertung der Messsignale erfolgt üblicherweise mit einem Mikroprozessor.

Die erfindungsgemäße Vorrichtung weist eine Auswerteeinheit auf, die auf Grundlage eines von dem Messgerät erzeugten Messergebnisses eine Zustandsinformation über den Zustand des mechanischen Bauteils, bei dem im Einsatz des Bauteils zumindest ein Teil des Bauteils relativ zu einem anderen Bauteil bewegt wird, ausgibt. Insbesondere bevorzugt besteht zwischen dem Messgerät und der Auswerteeinheit eine Signalleitung, entlang der insbesondere bevorzugt ein elektrisches oder ein optisches Signal zwischen dem Messgerät und der Auswerteeinheit ausgetauscht werden kann. Dabei ist insbesondere bevorzugt eine Größe des Signals, beispielsweise dessen Stärke oder dessen zeitlicher Verlauf abhängig von einer charakteristischen Größe der von dem Messgerät bestimmten Spannung oder der Änderung der Spannung.

Die Ausgabe der Zustandsinformation kann sehr vereinfacht sein, so kann beispielsweise vorgesehen sein, dass die Auswerteeinheit beim Erreichen eines bestimmten, nicht gewünschten Zustandes eine Zustandsinformation in Form eines optischen Reizes (beispielsweise geht ein rotes Licht an) oder eines Tons abgibt, während das Fehlen eines optischen Reizes oder eines Tons die Information darüber ist, dass der Zustand des mechanischen Bauteils, bei dem im Einsatz des Bauteils zumindest ein Teil des Bauteils relativ zu einem anderen Bauteil bewegt wird, den unerwünschten Zustand noch nicht erreicht hat. Auch ist es denkbar, dass die Zustandsinformation graduell, beispielsweise nach einem Ampelsystem, abgeben wird. Auch ist es denkbar, dass mittels der Erfindung konkrete Aussagen über den Zustand des mechanischen Bauteils, bei dem im Einsatz des Bauteils zumindest ein Teil des Bauteils relativ zu einem anderen Bauteil bewegt wird, getroffen werden können, beispielsweise nach wieviel weiteren Betriebsstunden des mechanischen Bauteils, bei dem im Einsatz des Bauteils zumindest ein Teil des Bauteils relativ zu einem anderen Bauteil bewegt wird, mit dem Ausfallen eines bestimmten Bauteils zu rechnen ist.

In einer bevorzugten Ausführungsform ist in der Auswerteeinheit eine Tabelle abgelegt, in der eine jeweilige Zustandsinformation über den Zustand des mechanischen Bauteils einem jeweiligen Messergebnis des Messgeräts zugeordnet ist. In dieser Ausführungsform arbeitet die Auswerteeinheit somit mit einer "look up-Table". In dieser Tabelle können Erfahrungswerte eingetragen werden, die sich mittels einfacher Prüfstanduntersuchungen ermitteln lassen.

Die erfindungsgemäße Vorrichtung weist eine Spannungsquelle als Signalgenerator auf, mit der eine Spannung an der Motorwelle über ein mechanisches Bauteil angelegt werden kann. Für das Bestimmen bestimmter der Spannung bzw. für das Bestimmen bestimmter Änderungen der Spannung ist es notwendig, eine Spannung an der Motorwelle über das mechanische Bauteil anzulegen. Indem die Vorrichtung mit einer Spannungsquelle ausgestattet wird, wird die erfindungsgemäße Vorrichtung autark.

Die erfindungsgemäße Vorrichtung ist dazu ausgebildet, ein Eingangssignal an der Motorwelle in das mechanische Bauteil einzubringen.

Das as Messgerät kann so ausgeführt sein, dass es eine über dem mechanischen Bauteil anliegende Spannung über eine vorbestimmte Messperiode messen kann. Insbesondere bevorzugt ist in dieser Ausführungsform vorgesehen, dass eine Auswerteeinheit vorgesehen ist, die ein Modul zur Auswertung des Verlaufs der gemessenen Spannung mit einem multivariaten statistischen Verfahren während der Messperiode aufweist, wobei aus der Auswertung eine Zustandsinformation über den Zustand des bewegbaren mechanischen Bauteils ausgegeben wird.

Das beobachtete mechanische Bauteil ist erfindungsgemäß ein Lager.

Das erfindungsgemäße System weist das mechanische Bauteil und eine erfindungsgemäße Vorrichtung auf. Das erfindungsgemäße System beschreibt zum einen den Zustand, wenn, beispielsweise für eine individuelle Messung des Zustands des mechanischen Bauteils, die erfindungsgemäße Vorrichtung in der Weise mit dem mechanischen Bauteil verbunden ist, dass das Messgerät der erfindungsgemäßen Vorrichtung die Spannung oder die Änderung der Spannung an dem mechanischen Bauteil bestimmen kann. Das schließt nicht aus, dass das erfindungsgemäße System ein Trennen der erfindungsgemäßen Vorrichtung von dem mechanischen Bauteil erlaubt und das erfindungsgemäße System somit nur kurzzeitig (während der Messung) besteht. Gleichzeitig umfasst der erfindungsgemäße Systemanspruch integrierte Einheiten aus dem mechanischen Bauteil und der erfindungsgemäßen Vorrichtung. So lässt sich die Erfindung beispielsweise sehr gut für Onboard-Diagnosesysteme einsetzen, beispielsweise in Fahrzeugen, insbesondere in Schienenfahrzeugen oder Straßenfahrzeugen, insbesondere Kraftfahrzeugen oder beispielsweise an Produktionsanlagen, wie beispielsweise Walzwerken.

Das erfindungsgemäße Verfahren sieht vor, dass mit einem Messgerät eine Spannung oder die Änderung einer Spannung an dem mechanischen Bauteil bestimmt wird.

Es wird mit einer Spannungsquelle eine Spannung an die Motorwelle angelegt und mit einem Messgerät, das ein Voltmeter ist, welches ausgestaltet ist, an der Motorwelle anzukoppeln, die Spannungsdifferenz zwischen Stator und Erde ermittelt. Es kann mit der Auswerteeinheit der Verlauf der gemessenen Spannung während der Messperiode mit einem multivariaten statistischen Verfahren ausgewertet werden, wobei die Auswerteeinheit aus der Auswertung eine Zustandsinformation über den Zustand des bewegbaren mechanischen Bauteils ausgibt. Dieser Ausführungsform liegt die Erkenntnis zugrunde, dass nicht nur aus der Höhe einer zu einem bestimmten Zeitpunkt gemessenen Spannung eine Zustandsinformation über den Zustand des bewegbaren mechanischen Bauteils gewonnen werden kann, sondern dass beispielsweise auch aus einer Auswertung des Spannungsverlaufs mit einem multivariaten statistischen Verfahren über eine vorbestimmte Messperiode Zustandsinformationen über den Zustand des bewegbaren mechanischen Bauteils gewonnen werden können.

In einer Ausführungsform enthält die statistische Auswertung die Bestimmung der Häufigkeitsverteilung einzelner Spannungen über die vorbestimmte Messperiode. Beispielsweise kann als Ergebnis der statistischen Auswertung ein Histogramm erzeugt werden, das aufzeigt, welche Spannung innerhalb der vorbestimmten Messperiode wie häufig vorlag. Zur Vereinfachung und aus Übersichtlichkeitsgründen kann das Histogramm in den in ihm dargestellten Balken Spannungen zu Span-nungsbereichen zusammenfassen; der Balken des Histogramms zeigt dann an, wie häufig eine Spannung aus diesem Spannungsbereich vorlag.

In einer Ausführungsform vergleicht die Auswerteeinheit das Ergebnis der Auswertung mit einem multivariaten statistischen Verfahren des Spannungsverlaufs über eine vorbestimmte Messperiode mit dem Ergebnis der Auswertung mit einem multivariaten statistischen Verfahren des Spannungsverlaufs über eine gleichlange, jedoch früheren Messperiode. Dieser Ausführungsform liegt die Erkenntnis zugrunde, dass sich der Spannungsverlauf über eine Messperiode mit vorbestimmter Länge in Abhängigkeit des Zustands des Bauteils ändert. Deshalb wird es möglich, anhand des Vergleichs des Ergebnisses der Auswertung mit einem multivariaten statistischen Verfahren des Spannungsverlaufs über eine erste Messperiode mit dem Ergebnis der Auswertung mit einem multivariaten statistischen Verfahren des Spannungsverlaufs über eine zweite Messperiode, die gleichlang wie die erste Messperiode ist, eine Zustandsänderung des Bauteils festzustellen.

Das multivariate statistische Verfahren ist insbesondere ein statistisches Verfahren.

In einer Ausführungsform bewegt sich während der Durchführung des erfindungsgemäßen Verfahrens ein Teil des zu untersuchenden mechanischen Bauteils relativ zu einem anderen Teil des zu untersuchenden mechanischen Bauteils. Es ist jedoch auch denkbar, dass das erfindungsgemäße Verfahren erfolgreich an einem ruhenden Bauteil durchgeführt werden kann.

In einer Ausführungsform ist das Eingangssignal konstant. Es sind jedoch auch Ausführungsformen denkbar, bei denen das Eingangssignal zeitlich variiert, insbesondere eine Sinusform oder eine Pulsform aufweist. In einer bevorzugten Ausführungsform ist das Eingangssignal ein Puls, insbesondere ein Delta-Puls zur Bestimmung der elektrischen Eigenschaften des Bauteils. Das Eingangssignal kann pulsförmige Spannungsfunktionen, wie zum Beispiel ein Rechteckimpuls, ein Dreieckimpulse oder ein Sägezahnimpulse sein. Gute Ergebnisse lassen sich mit einer pulsförmigen Spannungsfunktion mit zumindest einer steilen Signalflanke, vorzugsweise mit einer steilen Eingangsflanke und einer steilen Ausgangsflanke erzielen. Die Grundfrequenz des Signals kann ebenfalls zum Erzielen guter Ergebnisse genutzt werden. Je nach Bewegungsstatus des zu untersuchenden Bauteils ermöglichen diese zwei Parameter durch ihre Abweichungen zum Referenzsignal, nützliche Informationen zu bekommen und dadurch den Zustand des mechanischen Bauteils zu bestimmen.

In einer Ausführungsform erfolgt die Bestimmung der mechanischen Eigenschaften des Bauteils aus der Ermittlung einer elektrischen Größe im Wege der Durchführung einer Referenzmessung, nach der dann die eigentliche Messung erfolgt.

Nachfolgend wird die Erfindung anhand von lediglich Ausführungsformen darstellenden Zeichnungen näher erläutert.

Darin zeigen:
- Fig. 1: einen schematischen Querschnitt durch einen Teil eines Kugellagers,
- Fig. 2a: eine schematische Ansicht eines Versuchsaufbaus mit einem mechanischen Bauteil in Form eines Kugellagers und einem Messgerät,
- Fig. 2b: eine schematische Ansicht eines Teils des in Fig. 2a gezeigten Versuchsaufbaus, nämlich des beobachteten Lagers mit weiteren Details,
- Fig. 3: eine Grafik, die eine Referenzspannung an einem intakten und einem ungeschmierten Lager im Stillstand zeigt,
- Fig. 4: eine Grafik, die die Spannungsverläufe an dem intakten und an dem ungeschmierten Lager im Betriebszustand mit 10% der Nennfrequenz für einen Abschnitt von zwei Millisekunden in der Bremsphase zeigt,
- Fig. 5: ein Histogramm zum Vergleich der Referenzspannung beim intakten und beim ungeschmierten Lager im Stillstand und
- Fig. 6: ein Histogramm zum Vergleich der Häufigkeit von Spannungsbereichen bei dem intakten und bei dem ungeschmierten Lager in der Bremsphase mit 10% der Nennfrequenz.

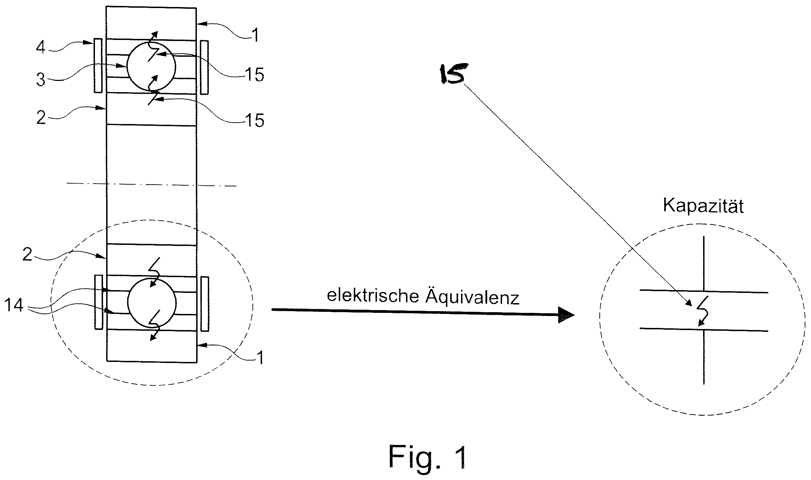

Fig. 1 zeigt einen Querschnitt eines Teils eines Kugellagers. Zu erkennen sind der Außenring 1, der Innenring 2 sowie eine Kugel 3 des Kugellagers. Ferner sind die seitlich angebrachten Dichtungen 4 zu erkennen. Ebenso eingezeichnet ist der zwischen dem Außenring 1 und der Kugel 3 vorhandene Schmierstoff 14 sowie der zwischen dem Innenring 2 und der Kugel 3 vorhandene Schmierstoff 14. Zur Verdeutlichung sind zudem unerwünschte Störströme 15 eingezeichnet, die von dem Innenring 2 über den Schmierstoff zur Kugel 3 und von der Kugel 3 über den Schmierstoff 14 zum Außenring 1 fließen. Derartige unerwünschte Ströme 15 werden häufig als Lagerströme bezeichnet. Fig. 1 verdeutlicht auch das elektrische Äquivalent der in dem gestrichelten Kreis hervorgehobenen Bauteile des Kugellagers.

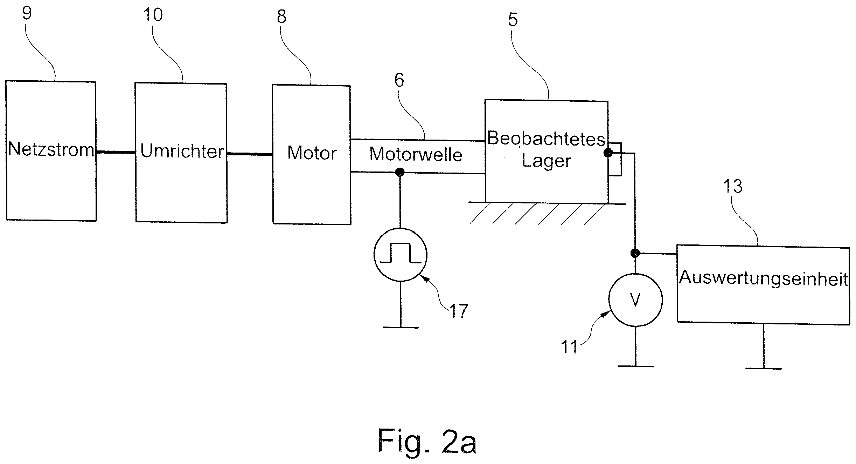

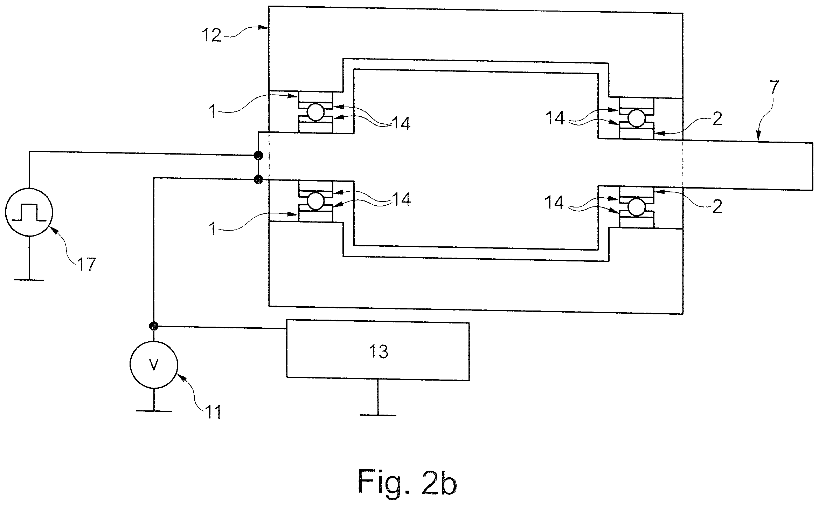

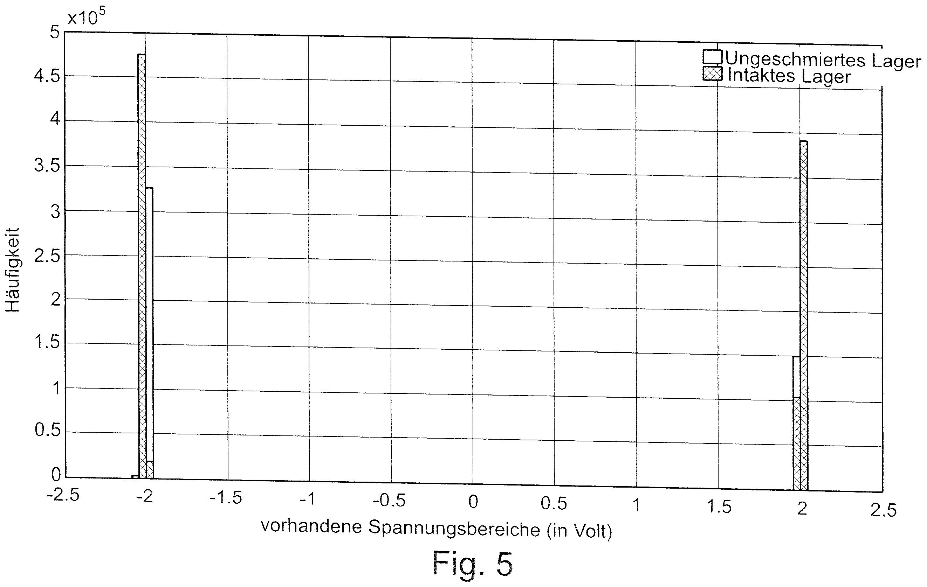

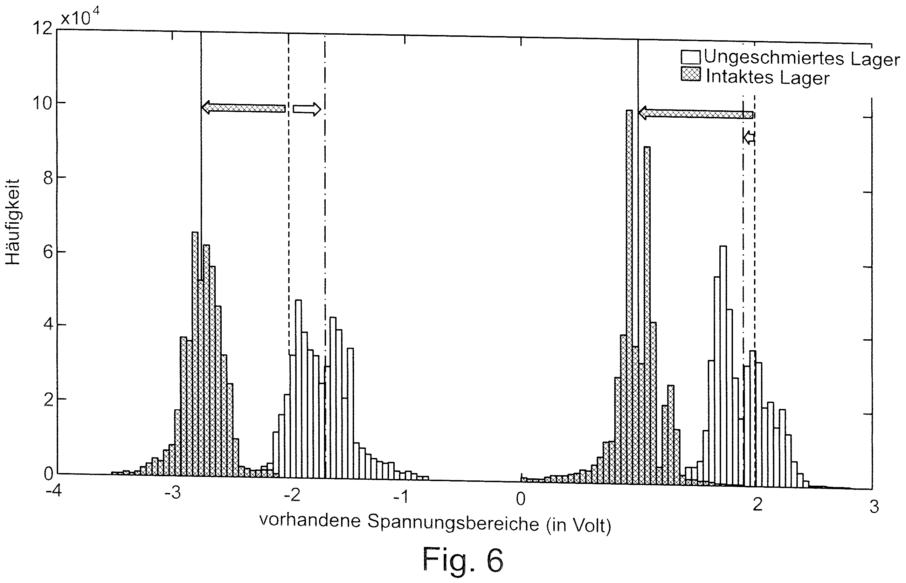

Die Fig. 2 zeigt einen Versuchsaufbau, der eingesetzt wurde, um die Wirksamkeit der Erfindung zu demonstrieren. Die Fig. 2a zeigt schematisch den Aufbau eines Lagerprüfstandes als Ausführungsform. Bei dem mechanischen Bauteil 5 handelt es sich um Kugellager, die einen von einer Motorwelle 6 angetriebenen Rotor 7 in einem Stator 12 lagern. Die Motorwelle 6 ist mit einem Motor 8 verbunden, der mittels einer Stromquelle 9 und einem der Stromquelle 9 nachgeschalteten Umrichter 10 versorgt wird. An der Motorwelle 6 wird mittels eines Signalgenerators 17 ein Spannungssignal eingekoppelt. Als Messgerät 11 wird ein Voltmeter verwendet, welches an dem Stator 12 angekoppelt ist und die Spannungsdifferenz zwischen dem Stator 12 und beispielsweise Erde (Masse) ermittelt. Die ermittelte Spannung wird in einer Auswerteeinheit 13 im Zeitbereich erfasst. Die Auswerteeinheit 13 berechnet von den zeitbezogenen Spannungsverläufen ein Histogramm (vgl. Fig. 5, Fig. 6). Die Bestimmung des Lagerzustands ergibt sich aus der Verteilung des Histogramms. Der Fig. 2b ist zu entnehmen, dass zwei Kugellager als mechanische Bauteile 5 verwendet werden, um den Rotor zu lagern. Von den Kugellagern kann der Zustand bestimmt werden, indem als elektrische Größe die zwischen dem Stator 12 und Erde (Masse) vorliegende Spannungsdifferenz ermittelt wird. Wie in Fig. 2a wird die ermittelte Spannung durch eine Auswerteeinheit 13 im Zeitbereich erfasst. Die Auswerteeinheit 13 berechnet von den zeitbezogenen Spannungsverläufen ein Histogramm (vgl. Fig. 5, Fig. 6). Die Bestimmung des Lagerzustands ergibt sich aus der Verteilung des Histogramms.

Zur Lagerschadenfrüherkennung wurden zwei Lager des gleichen Typs als Probe verwendet (ein intaktes Lager und ein defektes, d.h. ungeschmiertes Lager). Ein Rechtecksignal mit einer Grundfrequenz von 3 kHz und einer Amplitude von 2V (2V, -2V) wurde als Referenzsignal benutzt.

Es wurden zwei Betriebszustände betrachtet, nämlich der Stillstand der Kugellager als Referenz sowie ein kurzen Zeitabschnitt in der Bremsphase (Reduktion der Drehzahl) bei 10% der maximalen Drehzahl des Motors/Lagers.

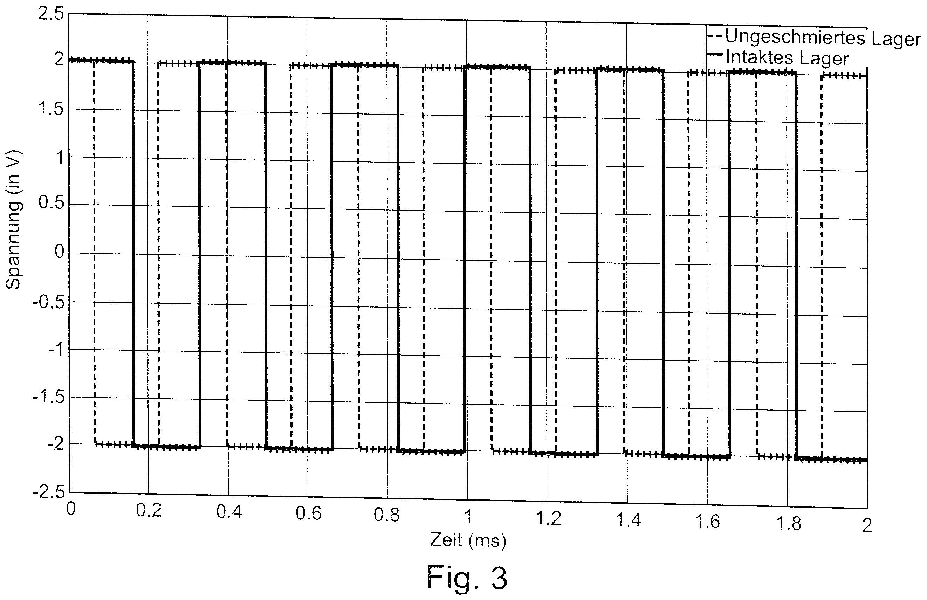

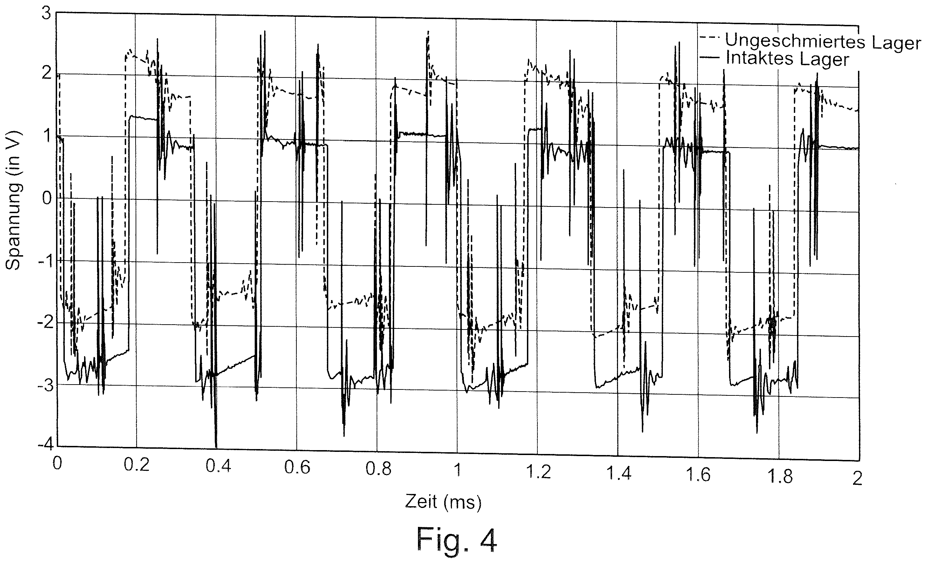

In Fig. 3 und 4 repräsentiert die Y-Achse die Spannung die X-Achse die Zeit. In den Fig. 5 und 6 repräsentiert die Y-Achse die Häufigkeit der Spannungsbereiche und die X-Achse die vorhandenen Spannungsbereiche.

Die Fig. 3 zeigt die Spannungsverläufe der Referenzspannung an den beiden Lagern über Zeit im Stillstand. Die Phasenverschiebung ist hier ohne Relevanz, da die Versuche nacheinander durchgeführt wurden. Zu erkennen ist allerdings, dass kein Amplitudenunterschied zwischen den beiden Lagern im Stillstand festzustellen ist. Dies ist im Stillstand auch so zu erwarten, da sich im Stillstand kein signifikanter Schmierfilm im Lager einstellt. Gleichspannungsunterschied zwischen den Referenzspannungen lag bei 8,9mV im Stillstand.

Die Fig. 4 zeigt die Spannungsverläufe der beiden Lager über der Zeit während der Bremsphase mit 10% der maximalen Drehzahl. Die Spannungsverläufe der beiden Kurven zeigen transiente Vorgänge, die durch die Drehbewegung der Lager verursacht werden. Während der Spannungsverlauf bei dem ungeschmierten Lager nahezu sym metrisch bleibt, verschiebt sich die Spannungsamplitude des intakten Lagers um mehr als 800mV nach unten. Der Gleichspannungsunterschied zwischen den Lagern lag bei 932mV in diesem Abschnitt der Bremsphase.

Die Fig. 5 zeigt die Häufigkeit der Spannungsbereiche an den beiden Lagern im Stillstand. Es ist festzustellen, dass alle vorhandenen Spannungsbereiche bei den maximalen Amplituden der Referenzspannung konzentriert sind und keine signifikanten Spannungsstreuungen in anderen Bereichen vorhanden sind.

Die Fig. 6 zeigt das Histogramm der Häufigkeiten der Spannungsbereiche an den beiden Lagern im Betriebszustand mit 10% der maximalen Drehzahl (einen kurzen Abschnitt in der Bremsphase). Bei dem ungeschmierten Lager kann eine Spannungsverschiebung, wie auch in Fig. 5 zu erkennen, festgestellt werden. Ferner kann ein klarer Unterschied zwischen den beiden Kurven (zwischen dem intakten Lager und zwischen dem ungeschmierten Lager) erkannt werden. Die Art der Verteilung der Spannungshäufigkeiten ermöglicht eine Zuordnung des Lagerzustandes.

Die in der Fig. 6 eingezeichneten vertikalen gestrichelten Linien repräsentieren die Amplitude der Referenzspannungen. Die vertikalen durchgezogenen bzw. gepunktet gestrichelten Linien repräsentieren die Mitte der Spannungsverteilungen für beide Lager. Die schwarzen und weißen Pfeile zeigen die Verschiebungsstärke und die Verschiebungsrichtung von der Amplitude der Referenzspannung.

Die Untersuchungen zeigen somit, dass durch das Betrachten der Spannung der Zustand eines mechanischen Bauteils ermittelt werden kann.

## Patentansprüche

1. Vorrichtung zur Bestimmung des Zustandes eines mechanischen Bauteils (5), das ein Lager ist, welches einen von einer Motorwelle (6) angetriebenen Rotor (7) in einem Stator (12) lagert, bei dem im Einsatz des Bauteils zumindest ein Teil des Bauteils relativ zu einem anderen Bauteil bewegt wird, wobei ein Messgerät (11), das eine elektrische Größe des mechanischen Bauteils (5) oder die Änderung einer elektrischen Größe bestimmen kann, und eine Auswerteeinheit (13), die auf Grundlage eines von dem Messgerät (11) erzeugten Messergebnisses eine Zustandsinformation über den Zustand des bewegbaren mechanischen Bauteils (5) ausgibt, vorhanden sind, **dadurch gekennzeichnet, dass** ein Signalgenerator (17) vorhanden ist, der ausgestaltet ist, ein Spannungssignal an der Motorwelle (6) einzukoppeln, und das Messgerät (11) ein Voltmeter ist, welches ausgestaltet ist, an dem Stator (12) anzukoppeln und die Spannungsdifferenz zwischen dem Stator (12) und Erde zu ermitteln.

2. Vorrichtung nach Anspruch 1, **gekennzeichnet durch** eine in der Auswerteeinheit (13) abgelegte Tabelle, in der eine jeweilige Zustandsinformation über den Zustand des bewegbaren mechanischen Bauteils (5) einem jeweiligen Messergebnis des Messgeräts (11) zugeordnet ist.

3. System aus dem mechanischen Bauteil (5) und einer Vorrichtung nach einem der Ansprüche 1 bis 2.

4. Verfahren zur Bestimmung des Zustandes eines mechanischen Bauteils (5), das ein Lager ist, welches einen von einer Motorwelle (6) angetriebenen Rotor (7) in einem Stator (12) lagert, wobei mit einem Messgerät (11) eine elektrische Größe oder die Änderung einer elektrischen Größe an dem mechanischen Bauteil (5) bestimmt wird, wobei eine Auswerteeinheit (13) auf Grundlage eines von dem Messgerät (11) erzeugten Messergebnisses eine Zustandsinformation über den Zustand des bewegbaren mechanischen Bauteils (5) ausgibt, **dadurch gekennzeichnet, dass** ein mittels eines Signalgenerators (17) erzeugtes Spannungssignal an der Motorwelle (6) eingekoppelt wird, und das Messgerät (11) ein Voltmeter ist, welches an dem Stator (12) angekoppelt wird und die Spannungsdifferenz zwischen dem Stator (12) und Erde ermittelt.

## Claims

1. Device for determining the state of a mechanical component (5), which is a bearing, which supports a rotor (7) driven by a motor shaft (6) in a stator (12), in which when the component is in use at least one part of the component is moved relative to another component, wherein a measuring device (11), which can determine an electrical quantity of the mechanical component (5) or the modification of an electrical quantity, and an evaluation unit (13), which on the basis of a result produced by the measuring device (11) outputs information on the state of the movable mechanical component (5), are present, **characterised in that** a signal generator (17) is present, which is designed to connect a voltage signal to the motor shaft (6), and the measuring device (11) is a voltmeter, which is designed to connect to the stator (12) and calculate the voltage difference between the stator (12) and earth.

2. Device according to Claim 1, **characterised by** a table stored in the evaluation unit (13), in which particular information on the state of the movable mechanical component (5) is assigned to a particular result from the measuring device (11).

3. System of the mechanical component (5) and a device according to one of Claims 1 to 2.

4. Method for determining the state of a mechanical component (5), which is a bearing, which supports a rotor (7) driven by a motor shaft (6) in a stator (12), wherein by means of a measuring device (11) an electrical quantity or the modification of an electrical quantity of the mechanical component (5) is determined, wherein an evaluation unit (13) on the basis of a result produced by the measuring device (11) outputs information on the state of the movable mechanical component (5), **characterised in that** a voltage signal produced by means of a signal generator (17) is connected to the motor shaft (6), and the measuring device (11) is a voltmeter, which is connected to the stator (12) and calculates the voltage difference between the stator (12) and earth.

## Revendications

1. Dispositif de détermination de l'état d'un composant mécanique (5), qui est un palier supportant un rotor (7) entraîné par un arbre de moteur (6) dans un stator (12), dans lequel, lors de l'utilisation du composant, au moins une partie du composant est déplacée par rapport à un autre composant, un dispositif de mesure (11), qui peut déterminer une grandeur électrique du composant mécanique (5) ou la variation d'une grandeur électrique, et une unité d'évaluation (13), qui, sur la base d'un résultat de mesure généré par le dispositif de mesure (11), émet une information d'état sur l'état du composant mécanique mobile (5), **caractérisé en ce qu'**un générateur de signaux (17) est prévu et conçu pour injecter un signal de tension sur l'arbre moteur (6), et le dispositif de mesure (11) est un voltmètre et conçu pour être couplé au stator (12) et pour déterminer la différence de tension entre le stator (12) et la masse.

2. Dispositif selon la revendication 1, **caractérisé par** un tableau stocké dans l'unité d'évaluation (13), dans lequel une information d'état respective concernant l'état du composant mécanique mobile (5) est associée à un résultat de mesure respectif du dispositif de mesure (11).

3. Système composé du composant mécanique (5) et d'un dispositif selon l'une des revendications 1 à 2.

4. Procédé de détermination de l'état d'un composant mécanique (5) qui est un palier supportant un rotor (7) entraîné par un arbre de moteur (6) dans un stator (12), une grandeur électrique ou la variation d'une grandeur électrique sur le composant mécanique (5) étant déterminée au moyen d'un dispositif de mesure (11), une unité d'évaluation (13) émettant, sur la base d'un résultat de mesure généré par le dispositif de mesure (11), une information d'état sur l'état du composant mécanique mobile (5), **caractérisé en ce qu'**un signal de tension généré au moyen d'un générateur de signaux (17) est injecté sur l'arbre moteur (6), et le dispositif de mesure (11) est un voltmètre qui est couplé au stator (12) et détermine la différence de tension entre le stator (12) et la masse.
